# EUROPÄISCHE PATENTANMELDUNG

(11) **EP 1 892 317 A1**
(43) Veröffentlichungstag der Anmeldung: **27.02.2008**
(21) Anmeldenummer: 06119493.2
(22) Anmeldetag: 24.08.2006
(51) Int. Cl.: C23C 14/35

(54) **Verfahren und Vorrichtung zur Kathodenzerstäubung.**

(71) Anmelder: Applied Materials GmbH & Co. KG, 63755 Alzenau (DE)
(72) Erfinder: Klug, Thomas, 63762 Großostheim (DE); Deppisch, Thomas, 63743 Aschaffenburg (DE)
(74) Vertreter: Lang, Christian

(57) **Zusammenfassung**

Die vorliegende Erfindung betrifft eine Vorrichtung und ein Verfahren zur Herstellung von leitfähigen Schichten einer organischen, Licht emittierenden Diode (OLED) mittels Kathodenzerstäubung (Sputtern) des Schichtmaterials oder eines Ausgangsmaterials für eine leitfähige Schicht der OLED-Vorrichtung, wobei eine Vakuumbeschichtungskammer bereit gestellt wird, in welcher ein Substrat (1) mit der Beschichtungsfläche (11) gegenüberliegend einer Kathodenanordnung (2, 3) mit mindestens einem Target aus dem zu zerstäubenden Material anordenbar ist, und wobei die Kathodenanordnung mindestens zwei mit Wechselspannung gekoppelt betriebene Elektroden (2, 3) umfasst.

## Beschreibung

### Technisches Gebiet

Die vorliegende Erfindung betrifft ein Verfahren und eine Vorrichtung zur Herstellung von leitfähigen Schichten einer organischen, lichtemittierenden Diode (OLED) mittels Kathoden-Zerstäubung (Sputtern) des Schichtmaterials oder eines Ausgangsmaterials für eine leitfähige Schicht der OLED-Vorrichtung.

### Stand der Technik

Leitfähige Schichten oder Elektroden-Schichten, wie Anodenschicht oder Kathodenschicht eines OLED-Schichtstapels werden üblicherweise durch Abscheiden einer metallischen Schicht, wie Aluminium erzeugt. Als Verfahren hierzu werden nach dem Stand der Technik Aufdampfverfahren oder indirektes Sputtern sowie direktes Sputtern unter gleichzeitigem Vorsehen entsprechender Schutzschichten verwendet.

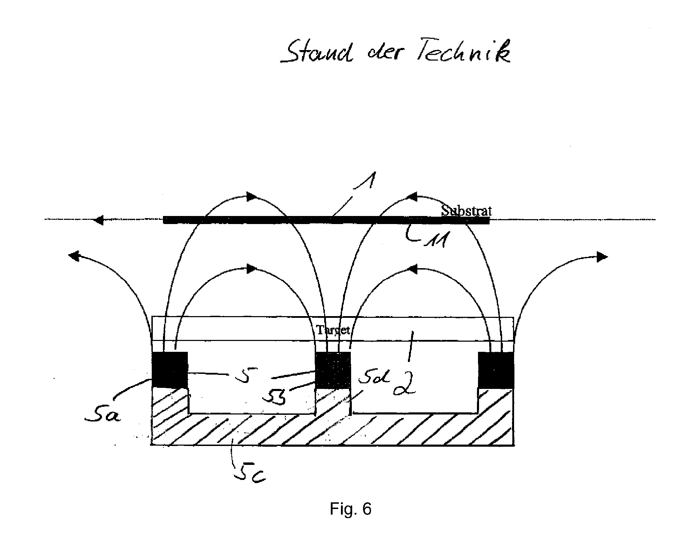

Aus dem Stand der Technik ist aus der US 6,797,129 B2 oder der US 2003/0224204 A1 bekannt, direktes Sputtern zur Aufbringung von metallischen Schichten in einer OLED-Vorrichtung zu verwenden. Eine entsprechende schematische Darstellung einer Sputter-Einrichtung ist in Figur 6 wiedergegeben. Sie zeigt ein Substrat 1 mit einer zu beschichtenden Oberfläche 11, welche gegenüberliegend einer Kathode 2, die gleichzeitig das Target und somit den Beschichtungswerkstoff zur Verfügung stellt, angeordnet ist. Die Kathode 2 ist als Längskathode bzw. Längstarget mit einer rechteckförmigen Oberfläche ausgebildet, wobei die Längserstreckung des Targets bzw. der Kathode 2 senkrecht zur Bildebene verläuft und die Darstellung der Figur 6 eine Querschnittsansicht ist.

Durch die Schaltung des Targets bzw. der Kathode 2 auf negatives Potential werden positiv geladene Ionen, vorzugsweise Argonionen aus dem zwischen der Kathode und der nicht dargestellten Anode gezündeten Plasma auf die Targetoberfläche beschleunigt, so dass durch die auf dem Target auftreffenden Ionen Targetmaterial zerstäubt (gesputtert) wird, welches sich dann auf der Substratoberfläche 11 ablagern kann.

Zur Erzielung einer hohen Ausbeute ist es aus dem Stand der Technik bekannt auf der substratabgewandten Seite des Targets 2 eine Magnetanordnung 5 zur Ausbildung eines Magnetrons vorzusehen, um durch im Magnetfeld gefangen gehaltenen Elektronen die Ionisierungsrate im Plasma zu erhöhen. Bei einer länglichen Kathode, wie sie in Figur 6 dargestellt ist, ist die Magnetanordnung üblicherweise durch einen äußeren Magnetring 5a und einen inneren Magnetring 5b bzw. einer Magnetreihe 5b ausgebildet, wobei beispielsweise die Magnete des äußeren Magnetrings 5a an der Targetseite ihren Nordpol aufweisen, während die Magnete des inneren Magnetrings 5b an der Targetseite ihren Südpol aufweisen.

Die Magnetringe 5a und 5b sind auf der Target abgewandten Seite durch ein Magnetjoch 5c kurzgeschlossen, wodurch das zum Target hin austretende Magnetfeld verstärkt wird. Das Magnetjoch 5c kann aus einer Platte bestehen oder Jochschenkel 5d in Form von der Platte hervorstehender Stege aufweisen, die zur Verbindung mit den Magnetringen 5a und 5b vorgesehen sind.

Wie in der Figur 6 zu sehen ist, erstreckt sich das Magnetfeld der Magnetanordnung 5 bis in den Substratbereich, so dass geladene Teilchen des Plasmas und insbesondere Elektronen die Substratoberfläche treffen können. Insgesamt kommt es bei einer Sputtervorrichtung zur Aufrechterhaltung des Stromflusses für die Energieversorgung immer auch zu einem Elektronenfluss, so dass dadurch auch grundsätzlich eine Beschädigung von empfindlichen Schichten auf dem Substrat, wie beispielsweise einer OLED-Vorrichtung zu befürchten sind.

Entsprechend sind zum Schutz der bereits auf dem Substrat befindlichen Schichten sog. Schutzschichten vorzusehen, die eine Beschädigung der bereits auf dem Substrat befindlichen Schichten durch auftreffende geladene Teilchen vermeiden sollen. Dies führt jedoch zu dem erhöhten Aufwand entsprechende Schutzschichten vorsehen zu müssen.

Entsprechend ist vorgeschlagen worden durch indirektes Sputtern, bei welchem zwei Targets mit aufeinander zuweisenden Sputterflächen eingesetzt werden, die Beschädigungen der Schichten im Schichtstapel einer OLED-Vorrichtung beim Aufbringen einer metallischen leitfähigen Schicht zu vermeiden (EP 1 524 706 A2). Allerdings wird durch das indirekte Sputtern, bei dem lediglich die Streubeschichtung das Substrat erreicht, nur eine geringe Schichtabscheiderate erzielt. Außerdem ist der Reinigungsaufwand für derartige Anlagen sehr hoch, da der Großteil des zerstäubten Materials nicht auf dem Substrat abgeschieden wird. Dies hat auch den Nachteil, dass hohe Materialverluste eintreten.

Aufgrund der aus dem Stand der Technik bekannten Nachteile des Sputterns wird üblicherweise nach dem derzeitigen Stand der Technik Aluminium als leitfähige Schicht aufgedampft. Allerdings ist es aufgrund des sehr aggressiven Aluminiumdampfs aufwendig entsprechende Verdampfer zu gestalten, wobei diese bisher nur eine sehr kurze Lebensdauer aufweisen. Durch den entsprechend häufig notwendigen Ersatz der Verdampfer ist auch mit diesem Verfahren ein sehr hoher Aufwand verbunden.

### Darstellung der Erfindung

### Technische Aufgabe

Es ist deshalb Aufgabe der vorliegenden Erfindung ein Verfahren und eine Vorrichtung zur Herstellung von leitfähigen Schichten einer organischen, lichtemittierenden Diode (OLED) bzw. einer entsprechenden OLED-Vorrichtung zu schaffen, bei dem bzw. der in effektiver Weise die leitfähigen Schichten auf einem Substrat abgeschieden werden können, welches bereits einen Teil des Schichtstapels für die OLED-Vorrichtung umfasst, ohne diese zu beschädigen. Ferner soll die Vorrichtung einfach aufgebaut und das Verfahren einfach durchgeführt werden können.

### Technische Lösung

Diese Aufgabe wird gelöst mit einem Verfahren mit den Merkmalen des Anspruchs 1 sowie einer Vorrichtung mit den Merkmalen des Anspruchs 15. Vorteilhafte Ausgestaltungen sind Gegenstand der abhängigen Ansprüche.

Die Erfindung zeichnet sich dadurch aus, dass zum Sputtern (Kathodenzerbstäuben) von leitfähigen Schichten, wie Metallschichten aus Silber, Aluminium und dgl. oder Legierungen dieser Elemente, sowie leitfähigen Oxydschichten, wie beispielsweise Indium-Zinn-Oxyd (ITO) auf OLED-Vorrichtungen direktes Sputtern mit aufeinander zugewandten Sputter- und Beschichtungsflächen verwendet wird, wobei jedoch mindestens zwei Sputterkathoden bzw. -elektroden vorgesehen sind, die als Zwillingskathoden bzw. -elektroden miteinander gekoppelt sind und mit Wechselspannung betrieben werden. Auf diese Weise wird jede der Sputterkathoden bzw. -elektroden abwechselnd als Anode und Kathode geschaltet. Dies bewirkt beim Sputterprozess, dass neben dem gegenüber der aktuellen Sputterkathode auf positiverem Potential befindlichen Substrat zusätzlich eine Anode mit deutlich positiverem Potential vorhanden ist, so dass Elektronen nicht auf das Substrat oder weit weniger stark auf das Substrat beschleunigt werden, sondern vielmehr auf die zweite Sputterkathode, die aktuell als Anode geschaltet ist. Auf diese Weise wird verhindert, dass Elektronen auf das Substrat und die darauf befindlichen organischen Schichten gelangen. Entsprechend kann auch die schädliche Wirkung der auftreffenden Elektronen oder allgemein geladenen Teilchen beseitigt oder zumindest verringert werden.

Mit einem derartigen Verfahren und einer entsprechenden Vorrichtung ist es somit möglich die hohen Sputterraten bzw. Schichtwachstumsraten von direktem Sputtern, bei dem die Zerstäubungsfläche des Targets der zu beschichtenden Substratoberfläche gegenüberliegt, mit einer schonenden Beschichtung zu verbinden, so dass die bereits auf dem Substrat befindlichen organischen Schichten der OLED-Vorrichtung nicht beschädigt werden.

Vorzugsweise sind die Zerstäubungsfläche des Targets und die zu beschichtende Substratoberfläche parallel zueinander ausgerichtet, so dass sich die zerstäubten Partikel von der Targetoberfläche in idealisierter Vorstellung auf kürzestem Weg senkrecht zur Beschichtungsoberfläche des Substrats bewegen.

Nach einer alternativen Ausgestaltung können die Targetoberfläche bzw. -oberflächen und die zu beschichtende Substratoberfläche jedoch auch einen Winkel zueinander einschließen, der beispielsweise 0° bis 45°, insbesondere 0° bis 15° oder höchst vorzugsweise 0° bis 9° betragen kann. Durch die zur Substratoberfläche geneigte Anordnung des Targets und/oder der gesamten Kathodenanordnungen bei plattenförmigen Längskathoden oder -targets wird erreicht, dass jeweils die der beiden Elektrodenanordnungen, welche gerade als Anode fungiert, näher an das Plasma gerückt wird, um so effektiver geladenen Teilchen, insbesondere Elektronen absaugen zu können.

Durch die geneigte Anordnung der Targets und/oder Kathodenanorndungen zur Substratoberfläche ergibt sich vorteilhafterweise eine winklige Anordnung der Targetoberflächen und/oder Kathodenanordnungen der Zwillingskathoden bzw. -elektroden zueinander, wobei diese einen Winkel von 180° bis 90°, vorzugsweise 180° bis 120°, insbesondere 180° bis 150° und höchst vorzugsweise 180° bis 162° einschließen. Letztendlich ergibt sich eine V-förmige Anordnung der Zwillingskathoden bzw. -elektroden.

Vorzugsweise wird die Kathodenanordnung mit den beiden abwechselnd als Anode und Kathode betriebenen Elektroden mit Hochfrequenzspannung (radio frequency rf) oder Mittelfrequenzspannung (MF) betrieben, deren Frequenzbereich auf dem vorliegenden technischen Gebiet allgemein bekannt ist. (RF > 10.000 - 1.000000 Hz, 10.000 - 1.000000 Hz > MF > 500 -1.000 Hz).

Zur Vermeidung des Auftreffens von Elektronen auf der Substratoberfläche kann das Substrat zusätzlich eine Bias-Spannung, insbesondere eine negative Bias-Spannung aufweisen.

Vorzugsweise sind die Kathoden bzw. Elektroden als Magnetrons ausgebildet, d.h. es ist eine Magnetanordnung auf oder an der dem Substrat abgewandten Seite der Kathode bzw. des Targets vorgesehen, um durch die Ausbildung eines Magnetfeldes über der Targetoberfläche Elektronen in diesem Bereich zu konzentrieren und die Ionisierungsrate für den Sputterprozess zu erhöhen.

Um zu vermeiden, dass an den an der Targetoberfläche austretenden Magnetfeldlinien entlang Elektronen mit Targetpotential in Richtung des Substrats beschleunigt werden, ist nach einer vorteilhaften Ausgestaltung vorgesehen das Target im Bereich nahezu senkrecht austretender Magnetfeldlinien aus einem nicht leitfähigen Material, insbesondere Keramik zu bilden.

Eine weitere Maßnahme, die zusätzlich oder alternativ vorgesehen werden kann, um die Beaufschlagung des Substrats mit geladenen Teilchen und insbesondere Elektronen zu vermeiden bzw. zu verringern, und für die sowohl in Kombination mit dem ersten Aspekt der Erfindung als auch separat Schutz beansprucht wird, besteht darin eine (zweite) Magnetanordnung vorzusehen, die im Bezug zum zu beschichtenden Substrat so angeordnet ist, dass geladene Teilchen und insbesondere Elektronen am Erreichen des Substrats gehindert werden.

Dies kann insbesondere dadurch erreicht werden, dass durch die zweite Magnetanordnung das Magnetfeld der ersten Magnetanordnung auf den B ereich vor dem Target konzentriert und insbesondere in der Substratebene neutralisiert wird, und zwar insbesondere im Bezug auf senkrecht zu dem Substrat orientierte Magnetfeldkomponenten.

Dies kann in einfacher Weise dadurch realisiert werden, dass die zweite Magnetanordnung spiegelsymmetrisch zur ersten Magnetanordnung ausgebildet wird, wobei die Substratebene als Spiegelebene gewählt wird. Damit wird sichergestellt, dass die senkrecht zum Substrat stehenden Komponenten des Magnetfeldes in der Substratebene neutralisiert sind.

Ferner kann zusätzlich oder alternativ eine elektrische Sperreinrichtung, die zwischen Kathodenanordnung und Substrat wirkt, vorgesehen werden, insbesondere eine mit einem entsprechenden Potential betriebene Gitterelektrode oder ein elektrisches Sperrfeld, welches elektrisch geladene Teilchen, insbesondere Elektronen von dem Substrat abhält.

Prinzipiell ist es auch möglich, zwischen Substrat und Kathodenanordnung einen Faradayischen Käfig vorzusehen, der das Erreichen der Substratoberfläche für geladene Teilchen und insbesondere Elektronen verhindert.

Die vorliegende Erfindung kann sowohl mit ringförmigen bzw. scheibenförmigen Elektroden bzw. Targets, länglichen, rechteckförmigen Elektroden bzw. Targets oder zylinderrohrförmigen Elektroden bzw. Targets verwirklicht werden, wobei insbesondere bei der Verwendung von Magnetrons die Magnetanordnungen auch bewegt werden können. Insbesondere bei Verwendung von zylinderrohrförmigen Targets bzw. Elektroden ist auch eine Dreh- bzw. Schwenkbewegung der Elektroden bzw. Targets möglich.

Mit all diesen Maßnahmen kann erreicht werden, dass die schädlichen Wirkungen des Sputterns auf die bereits auf einem Substrat befindlichen Schichten einer OLED-Vorrichtung vermieden bzw. verringert werden und somit ein leistungsfähiges und effektives Sputterverfahren eingesetzt werden kann.

### Kurze Beschreibung der Zeichnungen

Weitere Vorteile, Kennzeichen und Merkmale der vorliegenden Erfindung werden bei der nachfolgenden detaillierten Beschreibung von Ausführungsbeispielen anhand der beigefügten Zeichnungen deutlich. Die Zeichnungen zeigen hierbei in rein schematischer Weise in

Abb. 1 eine schematische Darstellung wesentlicher Teile einer erfindungsgemäßen Vorrichtung;

Abb. 2 eine schematische Darstellung wesentlicher Teile einer zweiten Ausführungsform einer erfindungsgemäßen Vorrichtung;

Abb. 3 eine schematische Darstellung wesentlicher Teile einer dritten Ausführungsform einer erfindungsgemäßen Vorrichtung;

Abb. 4 eine schematische Darstellung wesentlicher Teile einer vierten Ausführungsform einer erfindungsgemäßen Vorrichtung; und in

Abb. 5 eine schematische Darstellung wesentlicher Teile einer fünften Ausführungsform einer erfindungsgemäßen Vorrichtung.

Abb. 6 zeigt eine Vorrichtung nach dem Stand der Technik.

### Weg(e) zur Ausführung der Erfindung

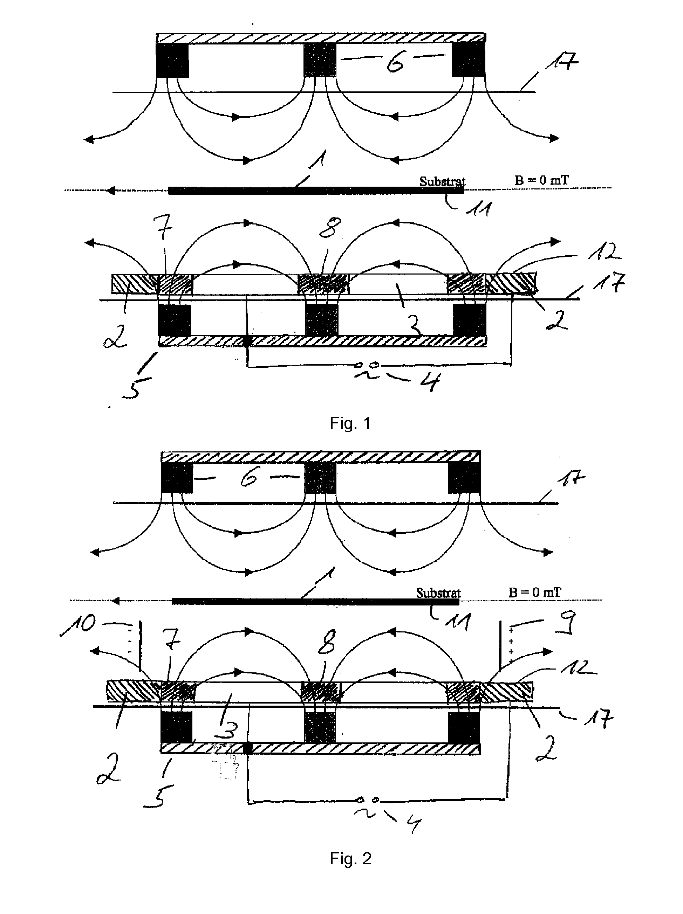

Die Abb. 1 zeigt in schematischer Darstellung ein Substrat 1, welches eine Beschichtungsfläche 11 aufweist, auf der mindestens eine leitfähige Schicht aus Metall, wie Silber, Silberlegierungen, Aluminium oder dergleichen oder aus leitfähigen Oxyden, wie insbesondere Indium-Zinn-Oxyd (ITO) abgeschieden werden soll. Das Substrat kann insbesondere bereits Teilschichten eines für eine OLED-Vorrichtung erforderlichen Schichtstapels aufweisen. Dies bedeutet, dass die Aufbringung der leitfähigen Schicht besonders schonend und sorgsam erfolgen muss, um eine Beschädigung der empfindlichen, bereits aufgebrachten Schichten zu vermeiden.

Die Aufbringung erfolgt gemäß der Erfindung durch Kathoden-Zerstäubung (Sputtern), wobei zwei Kathoden bzw. Elektroden 2 und 3 vorgesehen sind, die an eine Wechselspannungsversorgung 4 angeschlossen sind, um abwechselnd als Kathode und Anode betrieben zu werden.

In dem gezeigten Ausführungsbeispiel der Abb. 1 sind die beiden Elektroden, die nachfolgend als Kathoden bezeichnet werden, da sie für die Zerstäubung des Schichtmaterials verantwortlich zeichnen, als konzentrisch angeordnete, ringförmige Kathoden 2 und 3 ausgebildet.

Die Kathoden weisen integriert oder separat vor den Kathoden angeordnete (nicht explizit dargestellte) Targets auf, die aus dem Zerstäubungsmaterial bestehen. Dieses kann identisch mit dem aufzubringenden Schichtmaterial sein oder als Basismaterial für aufzubringende Schichten dienen, wobei im letzteren Fall zusätzliche Komponenten beispielsweise über die Gasphase eingebracht werden können.

Die äußere ringförmige Kathode 2 und die innere ringförmige Kathode 3 und/oder die entsprechenden Targets sind durch einen ringförmigen, isolierenden Körper 7, der beispielsweise aus Keramik besteht, voneinander getrennt. Zusätzlich ist ein ebenfalls isolierender, scheibenförmiger Körper 8, beispielsweise ebenfalls aus Keramik, in der zentralen Aussparung der inneren Ringkathode 3 vorgesehen.

Unmittelbar benachbart zu den isolierenden Körpern 7 und 8 ist auf der von dem Substrat abgewandten Seite der Kathoden 2, 3 bzw. Targets eine Magnetanordnung 5 vorgesehen, bei der beispielsweise die Nordpole unterhalb des ringförmigen isolierenden Körpers 7 vorgesehen sind, während die Südpole unterhalb des scheibenförmigen isolierenden Körpers 8 angeordnet sind. Die Magnete sind durch ein Joch kurzgeschlossen, durch welches die Stromzuführung genauso wie durch die Kammerwand 17 elektrisch isoliert hindurchgeführt ist.

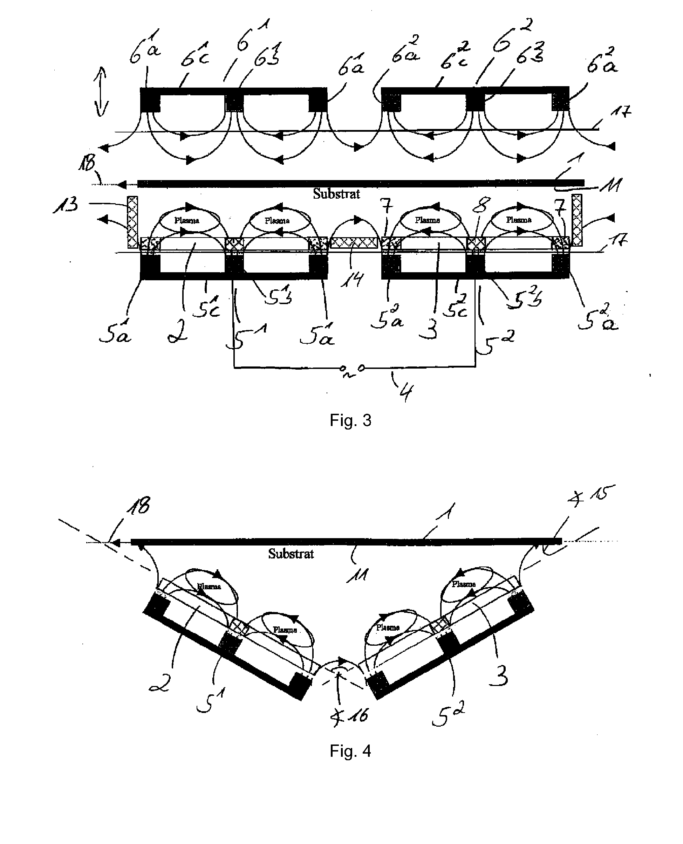

Anstelle einer ringförmigen konzentrischen Ausbildung der beiden gekoppelt betriebenen Kathoden 2 und 3 ist auch eine längliche Ausbildung der Kathoden mit einer parallelen Anordnung zueinander denkbar, wie sie in Fig. 3 bis 5 nachfolgend noch beschrieben sind. In jedem Fall ist eine entsprechende Magnetanordnung 5 vorgesehen, die aufgrund ihrer Anordnung zu einer möglichst effektiven und gleichmäßigen Zerstäubung des Beschichtungsmaterials (Target) führen soll. Dabei ist die Anordnung der Magnete und der isolierenden Körper 7, 8 im Bereich des Targets so gestaltet, dass die nahezu oder weitgehend senkrecht auf der Targetfläche 12 stehenden Magnetfeldlinien in Bereiche fallen, in denen die Targetoberfläche bzw. die Kathoden entsprechende isolierende Körper 7, 8 aufweisen, wie dies auch durch die entsprechenden Pfeile der Abb. 1 angedeutet ist. Damit wird verhindert, dass Elektronen aus den Bereichen, in denen die Magnetfeldlinien im Wesentlichen senkrecht auf der Targetoberfläche 12 stehen, mit ihrem Targetpotential in Richtung des Substrats beschleunigt werden können.

Neben der ersten Magnetanordnung 5 zur Ausbildung von Magnetron-Kathoden auf der vom Substrat abgewandten Seite der Kathoden bzw. des Targets ist, wie in den Fig. 1 und 2 zu sehen ist, zusätzlich eine zweite Magnetanordnung 6 vorgesehen, die mit ihrem Magnetfeld dem Magnetfeld der ersten Magnetanordnung 5 entgegenwirkt und insbesondere dafür sorgt, dass das Substrat in der Substratebene keinem wirksamen Magnetfeld mit zumindest senkrecht zur Substratebene orientierten Magnetfeldkomponente ausgesetzt ist. Insbesondere ist die zweite Magnetanordnung 6 spiegelsymmetrisch zur ersten Magnetanordnung 5 mit der Substratebene als Spiegelebene angeordnet, so dass durch das gleiche, entgegengesetzt gerichtete Magnetfeld eine Konzentrierung des Magnetfelds der ersten Magnetanordnung 5 auf den Bereich vor den Kathoden 2, 3 bzw. den Targets realisiert wird und der Substratbereich frei von einem effektiven Magnetfeld senkrecht zur Substratebene ist. Auf diese Weise kann zusätzlich zum Zwillings-Kathoden-Betrieb und zusätzlich oder alternativ zum Vorsehen von nicht leitfähigen Elementen in der Targetoberfläche bzw. den Kathoden erreicht werden, dass keine Elektronen auf das Substrat beschleunigt werden, wo diese die bereits aufgebrachten Schichten eines OLED-Schichtstapels beschädigen könnten.

Somit wird durch die Einstellung eines Magnetfelds bzw. des Verlaufs der Magnetfeldlinien zu der Beschichtungsoberfläche verhindert, dass geladene Teilchen, wie Ionen oder insbesondere Elektronen das Substrat mit den empfindlichen, bereits aufgetragenen Schichten des OLED-Schichtstapels erreichen. Auf diese Art wird durch die zweite Magnetanordnung eine magnetische Abschirmung des Substrates erreicht.

In Abb. 2 ist eine Vorrichtung dargestellt, welche weitgehend derjenigen aus Abb. 1 entspricht, so dass mit identischen Bezugszeichen ähnliche oder identische Komponenten bezeichnet sind und hier keiner weiteren Erläuterung bedürfen. Die Ausführungsform der Abb. 2 unterscheidet sich von derjenigen der Abb. 1 im Wesentlichen darin, dass als zusätzliche Maßnahme zur Abschirmung des Substrats vor geladenen Teilchen wie Ionen oder Elektronen ein elektrisches Feld durch die Elektroden 9 und 10 parallel zur Substratoberfläche bzw. Beschichtungsfläche 11 aufgebaut ist, so dass die geladenen Teilchen durch das elektrische Feld quasi abgesaugt werden. Durch diese zusätzliche oder alternativ vorzusehende Maßnahme kann eine Schädigung der bereits auf dem Substrat befindlichen Schichten bei der Aufbringung einer metallischen, leitfähigen Schicht weiter verhindert oder vermindert werden.

Die Abb. 1 und 2 stellen lediglich schematische Teildarstellungen einer entsprechenden Vorrichtung dar und beschränken sich im Wesentlichen auf die wichtigen Komponenten, die in oder an einer entsprechenden Vakuumbeschichtungskammer enthalten sind. Eine Kammer mit der Kammerwand 17 ist vorgesehen, um nahezu Vakuumbedingungen einstellen zu können und ein entsprechendes Arbeitsgas, wie beispielsweise Argon einführen zu können.

Die Figur 3 zeigt eine dritte Ausführungsform der vorliegenden Erfindung wobei hier rechteckförmige Elektroden 2 und 3, die gleichzeitig als Target fungieren, eingesetzt werden. Die Querschnittsansicht der Figur 3 zeigt somit ähnlich zu der Darstellung der Figur 6 lediglich den Schnittbereich der Bildebene, während die länglichen Elektroden bzw. Targets 2 und 3 in ihrer Längserstreckung senkrecht zur Bildebene verlaufen.

Unterhalb der Targets bzw. Elektroden 2 und 3 bzw. auf der substratabgewandten Seite ist jeweils eine Magnetanordnung 5¹ und 5² mit jeweils einem äußeren Magnetring 5¹a, 5²a und einem inneren Magnetring 5¹b und 5²b vorgesehen, so dass die Elektroden 2 und 3 als Magnetrons ausgebildet sind. Die entsprechenden Magnetfeldlinien sind schematisch durch die Pfeilanordnungen dargestellt, ebenso das im Vorfeld der Targets bzw. Elektroden 2 und 3 gebildete Plasma.

Der äußere Magnetring 5¹a der Magnetanorndung 5¹ der Elektrode 2 ist mit seinem Nordpol zur Targeseite ausgerichtet, während der innere Magnetring 5¹b bzw. die entsprechende Magnetreihe mit ihrem Südpol in Richtung des Targets ausgebildet ist.

Die Ausrichtung der Magnete der Zwillingselektrode 3 mit der Magnetanordnung 5² ist gerade umgekehrt gewählt, um insbesondere in den benachbarten Randbereichen im Bereich des Elements 14 eine günstige Magnetfeldlinienausbildung zu erhalten. Entsprechend weist dort der äußere Magnetring 5²a eine Ausrichtung der Magnete derart auf, dass die Südpole in Richtung der Elektrode 3 zeigen, während beim inneren Magnetfeldring 5²b bzw. der entsprechenden Magnetreihe der Nordpol Richtung Elektrode 3 ausgerichtet ist.

Sowohl bei der Elektrode 2 als auch bei der Elektrode 3 sind in der Mitte im Bereich des inneren Magnetrings 5¹b bzw. 5²b und an den Rändern im Bereich der äußeren Magnetringe 5¹a und 5²a elektrisch nicht leitfähige Füllstücke 7 bzw. 8 eingesetzt, um zu verhindern, dass dort die Magnetfeldlinien senkrecht zu dem Target bzw. der Elektrode 2, 3 heraustreten, was dazu führen könnte, dass Elektronen in Richtung des Substrats beschleunigt werden.

Die isolierenden Füllstücke 8 können zudem dazu dienen Zuleitungen, wie beispielsweise Gaszuführ- oder Abführleitungen (nicht dargestellt) oder die Stromversorgung in die Vakuumkammer zu führen.

Sowohl die isolierenden Füllstücke 7 und 8 im Mittelbereich der Elektroden 2 und 3 als auch die umgekehrte Ausrichtung der Magnete in den Magnetanordnungen 5¹ und 5² verhindern somit die Ausbildung von senkrecht auf das Substrat zulaufenden Magnetfeldlinien, die eine Beschleunigung von Elektronen in Richtung des Substrats bewirken könnten. Somit wird auch durch diese Maßnahmen verhindert, dass geladene Teilchen, und insbesondere Elektronen auf das mit empfindlichen organischen Schichten versehene Substrat beschleunigt werden.

Die äußeren Magnetringe 5¹a und 5²a sowie die inneren Magnetringe 5¹b und 5²b sind jeweils über ein magnetisches Joch 5¹c und 5²c miteinander magnetisch kurzgeschlossen, um die entgegengesetzt zum Target austretenden Magnetfeldlinien zu bündeln.

Da die Magnetanorndungen 5¹ und 5² sowohl außerhalb als auch innerhalb einer Vakuumkammer angeordnet sein können, kann sich der Aufbau der Kathoden bzw. Elektrodenanordnungen von dem in Figur 3 dargestellten Aufbau unterscheiden. Beispielsweise können bei einer Anordnung der Magnetanordnungen 5¹ und 5² innerhalb einer Vakuumkammer zusätzliche weichmagnetische Kathodenkörper vorgesehen sein, die die Magnetanordnungen 5¹ und 5² aufnehmen.

Am Rand der Elektroden 2, 3 und zwischen den Elektroden 2 und 3 können zusätzliche leitfähige Elemente 13 bzw. 14 vorgesehen sein, die auf ein geringes positives Potential gesetzt werden können, um geladene Teilchen und insbesondere Elektronen einzufangen.

Wie in Figur 3 ebenfalls zu sehen ist, sind spiegelbildlich zur Substratebene 18 zwei zweite Magnetanordnungen 6¹ und 6² vorgesehen, die identisch zu den Magnetanordnunge 5¹ und 5² aufgebaut sind und somit wiederum äußere Magnetringe 6¹a und 6²a sowie innere Magnetringe 6¹b und 6²b bzw. entsprechende Magnetreihen aufweisen. Auch diese sind wiederum über weichmagnetische Joche 6¹c und 6²c untereinander kurzgeschlossen. Auch die Ausrichtung der Magnete in den Magnetreihen 6¹a und 6²a bzw. 6¹b und 6²b entspricht derjenigen der Magnetanordnungen 5¹ und 5², so dass sich also gleiche Pole unmittelbar gegenüberliegen. Dies bewirkt, dass das Magnetfeld der Magnetanordnungen 5¹ und 5² in Richtung der Elektroden 2 und 3 gedrückt wird, so dass sich insbesondere in der Substratebene 18 die Magnetfelder neutralisieren. Auf diese Weise kann bewirkt werden, dass keine oder weniger geladene Teilchen, insbesondere Elektronen auf die zu beschichtende Substratoberfläche 11 gelangen, wo sie an den empfindlichen organischen Schichten der OLED-Vorrichtung Schäden anrichten könnten.

Wie der Doppelpfeil links der Magnetanordnung 6¹ zeigt, sind die Magnetanordnungen 6¹ und 6² insbesondere in Richtung der Substratebene 18 beweglich ausgebildet, um die Wirkungen in der Substratebene einstellen zu können.

Die Figur 4 zeigt eine weitere Ausführungsform, bei welcher die Targets bzw. Elektroden 2 und 3 und die zugehörigen Magnetanordnungen 5¹ und 5², also die gesamten Kathodenanordnungen geneigt zur Substratebene 18 ausgebildet sind, so dass die Elektroden- bzw. Targetoberfläche jeweils einen Winkel 15 mit der Substratebene 18 einschließt. Gleichzeitig bilden die Elektroden- bzw. Targetoberflächen der planaren Elektroden 2 und 3 ebenfalls einen Winkel 16 zwischen sich aus. Durch die winklige Anordnung kann bewirkt werden, dass die bei der Wechselspannung gerade als Anode geschaltete Elektrode 2 oder 3 dem Plasma näher ist, um negativ geladene Teilchen und insbesondere Elektronen abzusaugen und dadurch zu verhindern auf die Substratoberfläche zu gelangen. Der Winkel 15 kann sich dabei im Bereich von 0° bis 45° bewegen, wobei kleinere Winkel in der Größenordnung zwischen 0° und 9° bzw. 0° bis 15° bevorzugt sind. Entsprechend bildet sich der Winkel 16 bei einer spiegelbildlichen bzw. symmetrischen Anordnung der Elektroden 2 und 3 zu ihrer gemeinsamen Mittelachse aus.

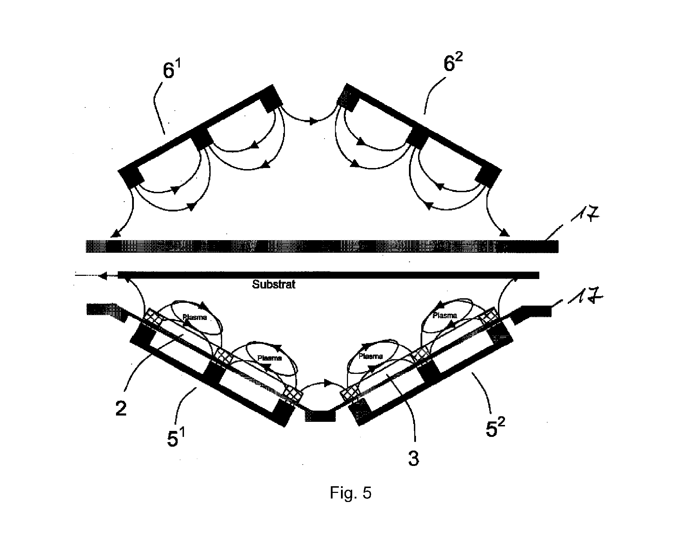

Bei der Ausführungsform der Figur 5 sind zusätzlich zur Ausführungsform der Figur 4 zweite Magnetanordnungen 6¹ und 6² vorgesehen, die in dem gezeigten Fall spiegelbildlich zu den Magnetanordnungen 5¹ und 5², also V-förmig angeordnet sind. Allerdings ist es selbstverständlich auch möglich, eine zur Substratebene parallele Anordnung der zweiten Magnetanordnungen 6¹ und 6¹ zu wählen.

Obwohl die vorliegende Erfindung detailliert in Bezug auf die dargestellten Ausführungsbeispiele beschrieben worden ist, stellen diese keine Einschränkung des Schutzbereichs dar, welcher durch die beigefügten Ansprüche definiert ist. Insbesondere können einzelne Komponenten und Aspekte der vorgestellten Ausführungsbeispiele weggelassen oder in anderer Weise miteinander kombiniert werden, ohne den Schutzbereich der vorliegenden Erfindung zu verlassen.

## Patentansprüche

1. Verfahren zur Herstellung von leitfähigen Schichten einer organischen, Licht emittierenden Diode (OLED) mittels Kathodenzerstäubung (Sputtern) des Schichtmaterials oder eines Ausgangsmaterials für eine leitfähige Schicht der OLED-Vorrichtung,
**dadurch gekennzeichnet, dass** eine Vakuumbeschichtungskammer bereit gestellt wird, in welcher ein Substrat (1) mit der Beschichtungsfläche (11) gegenüberliegend einer Kathodenanordnung (2, 3) mit mindestens einem Target aus dem zu zerstäubenden Material angeordnet wird, wobei die Kathodenanordnung mindestens zwei Elektroden (2, 3) umfasst, die mit Wechselspannung gekoppelt betrieben werden.

2. Verfahren nach Anspruch 1,
**dadurch gekennzeichnet, dass** das zu zerstäubende Material Silber, Silberlegierungen, Aluminium, Gold, Kupfer, transparente, leitfähige Oxide (TCO), Indiumzinnoxid (ITO) oder Basismaterialien hierfür umfasst.

3. Verfahren nach einem der vorhergehenden Ansprüche,
**dadurch gekennzeichnet, dass** die Zerstäubungsfläche (12) des Targets direkt der zu beschichtenden Substratoberfläche (11) gegenüber liegt.

4. Verfahren nach einem der vorhergehenden Ansprüche,
**dadurch gekennzeichnet, dass**die Targetoberfläche parallel zu der zu beschichtenden Substratfläche oder in einem Winkel (15) von 0° bis 45°, insbesondere 0° bis 30°, vorzugsweise 0° bis 15°, höchst vorzugsweise 0° bis 9° angeordnet sind.

5. Verfahren nach Anspruch 4,
**dadurch gekennzeichnet, dass**die Targetoberflächen zwischen sich einem Winkel (16) von 180° bis 90°, vorzugsweise 180° bis 120°, insbesondere 180° bis 150°, höchst vorzugsweise 180° bis 162° einschließen.

6. Verfahren nach einem der vorhergehenden Ansprüche,
**dadurch gekennzeichnet, dass** die Kathodenanordnung (2, 3) mit Hochfrequenzspannung (RF-Spannung) oder Mittelfrequenzspannung (MF-Spannung) betrieben wird.

7. Verfahren nach einem der vorhergehenden Ansprüche,
**dadurch gekennzeichnet, dass**die Kathodenanordnung mit gepulster Wechselspannung betrieben wird.

8. Verfahren nach einem der vorhergehenden Ansprüche,
**dadurch gekennzeichnet, dass** am Substrat eine Biasspannung, insbesondere eine negative Biasspannung angelegt wird.

9. Verfahren nach einem der vorhergehenden Ansprüche,
**dadurch gekennzeichnet, dass** mindestens eine erste Magnetanordnung (5) an den Kathoden zur Bildung von Magnetrons vorgesehen ist.

10. Verfahren nach Anspruch 9,
**dadurch gekennzeichnet, dass** das Target zumindest teilweise im Bereich nahezu senkrecht austretender Magnetfeldlinien aus einem nicht leitfähigen Material (7, 8), insbesondere Keramik gebildet ist.

11. Verfahren zur Herstellung von leitfähigen Schichten einer organischen, lichtemittierenden Diode (OLED) mittels Kathodenzerstäubung (Sputtern) des Schichtmaterials oder des Ausgangsmaterials für eine leitfähige Schicht der OLED-Vorrichtung oder Verfahren nach einem der vorhergehenden Ansprüche,
**dadurch gekennzeichnet, dass**eine Vakuumbeschichtungskammer bereitgestellt wird, in welcher ein Substrat (1) mit einer Beschichtungsfläche (11) gegenüberliegend einer Kathodenanordnung (2, 3) mit mindestens einem Target aus dem zu zerstäubenden Material angeordnet wird, wobei mindestens eine (zweite) Magnetanordnung (6) vorgesehen ist, welche so angeordnet ist, dass geladene Teilchen, insbesondere Elektronen am Erreichen des Substrats (1) gehindert werden.

12. Verfahren nach Anspruch 11,
**dadurch gekennzeichnet, dass** die zweite Magnetanordnung (6) so ausgebildet ist und insbesondere im Bezug zur ersten Magnetanordnung (5) so angeordnet ist, dass das Magnetfeld der ersten Magnetanordnung auf den Bereich vor dem Target konzentriert und insbesondere in der Substratebene neutralisiert wird.

13. Verfahren nach einem der Ansprüche 11 oder 12,
**dadurch gekennzeichnet, dass** die zweite Magnetanordnung (6) spiegelsymmetrisch zur ersten Magnetanordnung (5) mit der Substratebene als Spiegelebene ausgebildet und/oder angeordnet ist.

14. Verfahren nach einem der vorhergehenden Ansprüche,
**dadurch gekennzeichnet, dass** zwischen Kathodenanordnung (2, 3) und Substrat (1) eine elektrische Sperreinrichtung (9, 10), insbesondere ein Faradayscher Käfig, eine Gitterelektrode oder ein elektrisches Sperrfeld, zum Abblocken von elektrisch geladenen Teilchen, insbesondere Elektronen vor dem Substrat vorgesehen ist.

15. Verfahren nach einem der vorhergehenden Ansprüche,
**dadurch gekennzeichnet, dass**die Kathodenanordnung ringförmige, rechteckförmige oder zylinderförmige Targets oder Kathoden oder Elektroden, insbesondere Magnetrons umfasst, wobei vorzugsweise die Targets und/ oder Magnetrons beweglich, insbesondere im Falle einer Zylinderform rotierbar ausgebildet sind.

16. Vorrichtung zur Herstellung von leitfähigen Schichten einer organischen, Licht emittierenden Diode (OLED) mittels Kathodenzerstäubung (Sputtern), insbesondere nach einem Verfahren nach einem der vorhergehenden Ansprüche, mit einer Vakuumbeschichtungskammer, die so bestimmt und hergerichtet ist, dass ein Substrat (1) mit Teilschichten einer OLED-Vorrichtung mit der Beschichtungsfläche (11) gegenüberliegend einer Kathodenanordnung (2, 3) mit mindestens einem Target aus dem zu zerstäubenden Material anordenbar ist, wobei die Kathodenanordnung mindestens zwei mit Wechselspannung gekoppelt betriebene Elektroden (2, 3) umfasst.

17. Vorrichtung nach Anspruch 16,
**dadurch gekennzeichnet, dass** die Zerstäubungsfläche des Targets direkt der zu beschichtenden Substratoberfläche gegenüber liegt.

18. Vorrichtung nach einem der Ansprüche 16 oder 17,
**dadurch gekennzeichnet, dass** die Kathodenanordnung (2, 3, 4) mit Hochfrequenzspannung (RF-Spannung) oder Mittelfrequenzspannung (MF-Spannung) und/oder gepulster Wechselspannung betreibbar ist.

19. Vorrichtung nach einem der Ansprüche 16 bis 18,
**dadurch gekennzeichnet, dass**die Targetoberfläche parallel zu der zu beschichtenden Substratfläche oder in einem Winkel (15) von 0° bis 45°, insbesondere 0° bis 30°, vorzugsweise 0° bis 15°, höchst vorzugsweise 0° bis 9° angeordnet sind.

20. Vorrichtung nach einem der Ansprüche 16 bis 19,
**dadurch gekennzeichnet, dass**die Targetoberflächen zwischen sich einen Winkel (16) von 180° bis 90°, vorzugsweise 180° bis 120°, insbesondere 180° bis 150°, höchst vorzugsweise 180° bis 162° einschließen.

21. Vorrichtung nach einem der Ansprüche 16 bis 20,
**dadurch gekennzeichnet, dass** am Substrat (1) eine Biasspannung, insbesondere eine negative Biasspannung anlegbar ist.

22. Vorrichtung nach einem der Ansprüche 16 bis 21,
**dadurch gekennzeichnet, dass** mindestens eine erste Magnetanordnung (5) an den Kathoden (2, 3) zur Bildung von Magnetrons vorgesehen ist.

23. Vorrichtung nach Anspruch 22,
**dadurch gekennzeichnet, dass** das Target im Bereich nahezu senkrecht austretender Magnetfeldlinien aus einem nicht leitfähigen Material (7, 8), insbesondere Keramik gebildet ist.

24. Vorrichtung zur Herstellung von leitfähigen Schichten einer organischen, lichtemittierenden Diode (OLED) mittels Kathodenzerstäubung (Sputtern), insbesondere nach einem Verfahren nach einem der Ansprüche 1 bis 15, mit einer Vakuumbeschichtungskammer, die so bestimmt und hergerichtet ist, dass ein Substrat (1) mit Teilschichten einer OLED-Vorrichtung mit der Beschichtungsfläche (11) gegenüberliegend einer Kathodenanordnung (2, 3) mit mindestens einem Target aus dem zu zerstäubenden Material anordenbar ist, oder nach einem der vorhergehenden Ansprüche 16 bis 23,
**dadurch gekennzeichnet, dass**mindestens eine (zweite) Magnetanordnung (6) vorgesehen ist, welche so angeordnet ist, dass geladene Teilchen, insbesondere Elektronen am Erreichen des Substrats (1) gehindert werden können und/oder das Magnetfeld der ersten Magnetanordnung (5) auf den Bereich vor dem Target konzentriert und insbesondere in der Substratebene neutralisiert werden kann.

25. Vorrichtung nach Anspruch 24,
**dadurch gekennzeichnet, dass** die zweite Magnetanordnung (6) spiegelsymmetrisch zur ersten Magnetanordnung (5) mit der Substratebene als Spiegelebene ausgebildet und/oder angeordnet ist.

26. Vorrichtung nach einem der Ansprüche 16 bis 25,
**dadurch gekennzeichnet, dass** zwischen Kathodenanordnung (2, 3) und Substrat (1) eine elektrische Sperreinrichtung (9, 10), insbesondere ein Faradayscher Käfig, eine Gitterelektrode oder ein elektrisches Sperrfeld, zum Abblocken von elektrisch geladenen Teilchen, insbesondere Elektronen vor dem Substrat vorgesehen ist.

27. Vorrichtung nach einem der Ansprüche 16 bis 26,
**dadurch gekennzeichnet, dass**die Kathodenanordnung ringförmige, rechteckförmige oder zylinderförmige Targets oder Kathoden oder Elektroden, insbesondere Magnetrons umfasst, wobei vorzugsweise die Targets und/ oder Magnetrons beweglich, insbesondere im Falle einer Zylinderform rotierbar ausgebildet sind.

28. Vorrichtung nach einem der Ansprüche 24 bis 27,
**dadurch gekennzeichnet, dass**die zweite Magnetanordnung derart angeordnet ist, dass ihr Abstand zur Substratebene einstellbar ist.

29. Vorrichtung nach einem der Ansprüche 16 bis 28;
**dadurch gekennzeichnet, dass** die Vakuumbeschichtungskammer Teil einer Beschichtungsanlage, insbesondere in-line-Beschichtungsanlage für OLED-Vorrichtungen ist.
